# EUROPÄISCHE PATENTSCHRIFT

(11) **EP 3 641 965 B1**
(45) Veröffentlichungstag und Bekanntmachung des Hinweises auf die Patenterteilung: **20.03.2024**
(21) Anmeldenummer: 18733231.7
(22) Anmeldetag: 19.06.2018
(51) Int. Cl.: B22F 10/38, B22F 10/28, B22F 3/00, B22F 3/105, B33Y 30/00, B33Y 50/00, B33Y 50/02, B29C 64/393, G06F 30/20, G06N 99/00, G01N 25/72, G01N 29/12, G01N 29/24, G01B 11/16, G01B 9/02, B22F 10/80, B22F 10/85, B22F 12/90, G01B 11/06, G01B 15/04, G01N 29/04, G06N 3/08

(54) **VERFAHREN UND VORRICHTUNG ZUR ADDITIVEN FERTIGUNG**
METHOD AND DEVICE FOR ADDITIVE MANUFACTURING
PROCÉDÉ ET DISPOSITIF DE FABRICATION ADDITIVE

(30) Priorität: 20.06.2017 DE 102017210330; 17.10.2017 DE 102017124100
(43) Veröffentlichungstag der Anmeldung: 29.04.2020
(73) Patentinhaber: Carl Zeiss Industrielle Messtechnik GmbH, 73447 Oberkochen (DE)
(72) Erfinder: TOTZECK, Michael, 73525 Schwaebisch Gmuend (DE); KRAUTZ, Danny, 10249 Berlin (DE); SPENGLER, Diana, 73431 Aalen (DE); WOLF, Uwe, 99441 Magdala (DE); HAGEN, Christoph Hilmar Graf vom, 73525 Schwäbisch Gmünd (DE); HOLZNER, Christian, 91631 Wettringen (DE); OMLOR, Lars, 90489 Nürnberg (DE)
(74) Vertreter: Witte, Weller & Partner Patentanwälte mbB
(86) Internationale Anmeldenummer: PCT/EP2018/066304
(87) Internationale Veröffentlichungsnummer: WO 2018/234331

(56) Entgegenhaltungen:
- EP-A1- 2 537 642
- EP-A1- 3 034 207
- WO-A1-2016/082810
- DE-A1-102006 025 262
- US-A1- 2010 174 392
- US-A1- 2015 331 402
- US-A1- 2016 318 255
- Loucas Papadakis ET AL: "Numerical Modeling of Heat Effects during Thermal Manufacturing of Aero Engine Components", Proceedings of the World Congress on Engineering 2012 Vol III, 6. Juli 2012 (2012-07-06), Seiten 1-6, XP055259905, London, UK ISBN: 978-988-1925-22-0 Gefunden im Internet: URL:http://www.iaeng.org/publication/WCE20 12/WCE2012_pp1518-1523.pdf [gefunden am 2016-03-21]

## Beschreibung

Die vorliegende Anmeldung betrifft Verfahren und Vorrichtungen zur additiven Fertigung von Werkstücken. Eine derartige additive Fertigung wird häufig auch als 3D-Druck bezeichnet.

Bei der additiven Fertigung wird eine Form eines Werkstücks durch einen Auftrag, d.h. Hinzufügen, von Material realisiert. Insbesondere werden bei vielen additiven Fertigungsverfahren dreidimensionale Werkstücke schichtweise aufgebaut. Das unterscheidet die additive Fertigung von der subtraktiven Fertigung, bei der Material von einem Rohling abgetragen wird, um ein Werkstück mit einer gewünschten Form zu fertigen. Additive Verfahren gewinnen zunehmend an Bedeutung, da hier mittlerweile auch vergleichsweise komplexe Formen von Werkstücken durch entsprechende Programmierung einer Fertigungsvorrichtung, beispielsweise einem sogenannten 3D-Drucker, realisierbar sind.

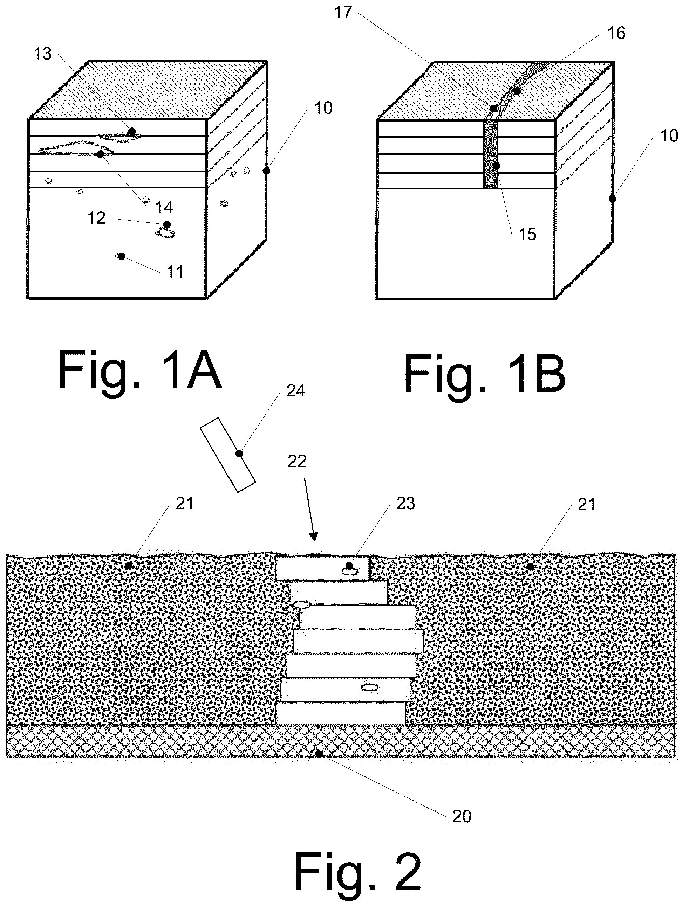

Während in der klassischen subtraktiven Fertigung die Qualität und insbesondere die Homogenität des verwendeten Materials durch den Fertigungsprozess nur minimal beeinflusst wird und im Wesentlichen von der Qualität des Materials des verwendeten Rohlings abhängt, werden bei der additiven Fertigung Material, Struktur und Form des Werkstücks gleichzeitig erzeugt. Damit können bei dem Herstellungsprozess leichter Materialfehler auftreten. Derartige Materialfehler können im Inneren eines Werkstücks liegen und sich als reine Materialfehler bemerkbar machen. Zusätzlich können sie an der Oberfläche eines Werkstücks zu Formfehlern führen. Beispiele hierfür sind in den Figuren 1A, 1B und 2 dargestellt.

Die Figuren 1A und 1B zeigen jeweils schematisch ein mit einem additiven Fertigungsverfahren in mehreren Schichten gefertigtes Werkstück 10. Wie in Figur 1A gezeigt, können bei dem additiven Herstellungsprozess Materialfehler auftreten, zum Beispiel Mikroporen 11, größere Poren 12, Risse 13 oder Schichtablösungen 14, bei welchen die hergestellten Schichten nicht korrekt aneinander haften. Zusätzlich können wie in Figur 1B gezeigt Materialspannungen auftreten (mit dem Bezugszeichen 15 symbolisiert), welche zu Oberflächenporen 17 oder Dellen 16 in der Oberfläche sowie zu Formfehlern führen können.

Ein typisches additives Fertigungsverfahren ist das Pulverbettverfahren, bei welchem einzelne Schichten eines Metallpulvers selektiv verhärtet werden. Auch hier können beim Verhärten Materialfehler auftreten, wie dies in Figur 2 schematisch dargestellt ist. Bei der Querschnittsansicht der Figur 2 befindet sich Metallpulver 21 auf einer Grundplatte 20. Durch schichtweises selektives Verhärten wird ein Werkstück 22 ausgebildet. Dieses schichtweise selektive Verhärten kann beispielsweise durch Sintern mit einem Laser 24 stattfinden (Lasersintern). Der Laser 24 in Fig. 2 dient dazu, das Metallpulver 21 lokal dort, wo eine Schicht des Werkstücks 22 zu erstellen ist, zu schmelzen, wobei sich das Metallpulver 21 dann nachfolgend verfestigt. Bei anderen Varianten kann ein Bindemittel verwendet werden. Dabei können sich Poren 23 oder andere bereits unter Bezugnahme auf die Figur 1A und 1B erläuterte Materialdefekte bilden.

Insbesondere bei sicherheitskritischen Anwendungen ist es wichtig, derartige Materialdefekte in Werkstücken erkennen zu können, um gegebenenfalls Maßnahmen ergreifen zu können, wie beispielsweise das Verwerfen eines Werkstücks.

Aus der EP 2 277 687 B1 und der EP 1 486 317 B1 sind Verfahren zur Bestimmung von Produktionsparametern für ein lasergesintertes Bauteil bekannt. Bei diesen Verfahren wird die additive Fertigung simuliert, und physikalische Eigenschaften des gefertigten Bauteils werden aus dem simulierten Herstellungsprozess berechnet, wie beispielsweise geometrische Abmessungen des Werkstücks und mechanische Eigenschaften. Diese berechneten Eigenschaften werden dann mit Eigenschaften des tatsächlich hergestellten Bauteils verglichen. Um diese zu ermitteln, muss das tatsächlich hergestellte Bauteil teilweise zerstört werden, je nach verwendeten Analyseverfahren und vermessenen Eigenschaften. Basierend auf dem Vergleich können dann Produktionsparameter optimiert werden.

Des Weiteren ist in WO 2016/082810 A1 ein Verfahren zur Entwicklung eines Herstellungsverfahrens beschrieben, bei dem ein Bauteil schichtweise durch Aufschmelzen von Pulvermaterial mittels einer Strahlquelle und anschließendem Erstarren des aufgeschmolzenen Pulvermaterials aufgebaut wird. In einem ersten Verfahrensabschnitt in Abhängigkeit von Prozessparametern werkstoffspezifische Eigenschaften eines Werkstoffs losgelöst von einer Bauteilgeometrie in einer multiskaligen Simulationskette ermittelt. In einem zweiten Verfahrensabschnitt wird unter Berücksichtigung der Prozessparameter und der werkstoffspezifischen Eigenschaften ein additiver Aufbau des Bauteils mit diesem Werkstoff simuliert. Andere Beispiele solcher Simulierung findet mann in US 2010/174392 A1, DE 10 2006 025262 A1, US 2016/318255 A1 und Loucas Papadakis ET AL: "Numerical Modeling of Heat Effects during Thermal Manufacturing of Aero Engine Components", Proceedings of the World Congress on Engineering 2012 Vol III, 6. Juli 2012 (2012-07-06), Seiten 1-6.

Diese Verfahren dienen also zur Optimierung von Produktionsparametern, erlauben aber keine Kontrolle einer laufenden Produktion und insbesondere keine zerstörungsfreie Detektion von Materialfehlern der laufenden Bauteilproduktion.

Aus der JP 2017/094728 A1 ist ein ultraschallbasiertes Verfahren zur Prozesskontrolle bekannt, die Schallemissionen des Pulverbetts wie beispielsweise des Pulverbetts 21 der Figur 2 nutzen. In der US 2017/0144250 A1 wird eine Schallemission einer Vorrichtung zum Aufbringen einer Lage aus Metallpulver, dort als "Recoater" bezeichnet, beschrieben. Aus der US 2017/0146489 A1 ist der Einsatz einer laserbasierten Ultraschallinspektion in einer additiven Fertigungsanlage basierend auf einem Pulverbettverfahren bekannt.

Die laserbasierte Ultraschallinspektion ist ein Verfahren, Ultraschall berührungslos mittels eines Lasers in einer Probe, beispielsweise einem durch ein additives Fertigungsverfahren hergestelltes Werkstück, zu erzeugen und wiederum berührungslos zu detektieren. Das Verfahren für sich ist beispielsweise in dem Kapitel "Optical Generation and Detection of Ultrasound" von Jean-Pierre Monchalin im Buch Physical Acoustics, edited by O. Leroy and M. A. Breazeale, Plenum Press, New York, 1991, beschrieben. Der Laserstrahl erzeugt im Material der Probe eine akustische Welle, die sich mit der Schallgeschwindigkeit im Material ausbreitet. Das Prinzip der Anregung thermolelastischer Wellen durch modulierte Laserstrahlung ist beispielsweise auch in Wang, X.; Xu, X.: Thermoelastic wave induced by pulsed laser heating", Applied Physics A 73, 2001, S. 107-114, beschrieben.

Inhomogenitäten im Inneren der Probe streuen die Schallwelle, von der ein Teil dadurch wieder zur Objektoberfläche zurückgeleitet wird. Dort führt sie zu einem temporären lokalen Höhenversatz der Objektoberfläche, zu einem lateralen Versatz oder beidem. Diese Bewegung kann durch ein zweites optisches System detektiert werden, zum Beispiel durch eine Topographiemessung und Laservibrometrie, die die durch den Dopplereffekt verursachte Frequenzverschiebung von Licht, das an der bewegten Oberfläche reflektiert wird, ausnutzt. Eine Beschreibung von verschiedenen Verfahren zur Detektion von Ultraschall an Oberflächen findet sich zum Beispiel in R. J. Dewhurstdag and Q. Shanddag, " Optical remote measurement of ultrasound", Measurement Science and Technology, Vol. 10, Nr. 11.

Derartige Ultraschallverfahren lassen sich jedoch nicht auf einfache Weise auf ein additiv gefertigtes Werkstück insbesondere in einem Pulverbett wie es in Figur 2 vorliegt, übertragen. In der üblichen Anwendung derartiger Verfahren zur zerstörungsfreien Materialprüfung ist das zu prüfende Objekt weitgehend homogen, und weist nur wenige Defekte auf. Im Gegensatz dazu stellt das Pulverbett 21 der Figur 2 eine hochgradig inhomogene Umgebung des Werkstücks 22 dar, in der Schallwellen stark gestreut werden. Der für den Streuquerschnitt relevante Impedanzsprung ist in einem Metallpulver sehr groß, da die Schallgeschwindigkeit in Luft ca. 330 m/s beträgt und in Stahl zum Beispiel 6000 m/s. Das entspricht einem Impedanzverhältnis von 20. Außerdem sind die Partikel des Metallpulvers frei (nicht aneinander gebunden), sodass neben Kristallgitterschwingungen wie in homogenen kristallinen Materialien auch makroskopische Bewegungen der Metallkörper des Metallpulvers möglich sind. Die Ausbreitung von Schallwellen in Pulvern ist zum Beispiel in Xiao Ping Jia, J. Laurent, Y. Khidas und V. Langlois, " Sound scattering in dense granular medium", Chinese Science Bulletin Vol. 54 Nr. 23, S. 4327-4336, 2009, oder in O. Mouraille and S. Luding: "Sound propagation in dense, frictional granular materials" in Powders and Grains 2005, Editors R. Garcia-Rojo, H. J. Herrmann und S. McNamara, S. 319, Leiden, 2005, A. A. Balkema Publishers beschrieben.

Ein wichtiger Skalierungsparameter für die Schallausbreitung ist dabei die Korngröße des Metallpulvers. Schallwellen mit einer Wellenlänge im Pulver von deutlich mehr als der Korngröße breiten sich im Pulver näherungsweise wie in einem homogenen Material aus, während Schallwellen mit einer Wellenlänge kleiner der Korngröße durch die Körner stark gestreut werden.

Die starke Streuung im Pulver führt zu einer Überlagerung des Signals, welches von Defekten in dem Werkstück herrührt, mit einem starken Untergrund. Erschwerend kommt dazu, dass mit additiven Fertigungsverfahren hergestellte Strukturen häufig filigran und komplex sind, d.h. sie weisen im Verhältnis zu ihrem Volumen eine große, komplex gestaltete Oberfläche auf, die ebenfalls Schallwellen stark streut.

Daher ist das mit derartigen Verfahren erfasste akustische Streusignal komplex und setzt sich aus einem großen Beitrag aus dem Pulverbett, einem mittelgroßen Beitrag aus der Oberfläche des Werkstücks und einem vergleichsweise kleinen Beitrag durch Materialdefekte zusammen. Daher kann es schwierig sein, aufgrund solcher Signale mit herkömmlichen Herangehensweisen Materialfehler korrekt zu detektieren. Bei der Analyse ist dabei zudem zu beachten, dass ein Teil der Fehler, die bei der additiven Fertigung auftreten können, kumulativ ist, d.h. sie zeigen erst Auswirkungen, nachdem eine Reihe von Schichten gefertigt wurden. Beispielsweise können durch Spannungen in einer obersten Lage Lagen darunter sich ablösen, oder es können sich darin Risse bilden. Ob sich bildende Poren kritisch sind, hängt auch davon ab, wie viele Poren sich in der Nachbarschaft befinden. Zudem bilden sich Spannungen im Material häufig erst nach mehreren Lagen aus.

Ein weiteres bekanntes Verfahren zur zerstörungsfreien Prüfung von Werkstücken ist die elektronische Speckle-Interferometrie (ESPI). Die DE 10 2014 202 020 B4 beschreibt den Einsatz der elektronischen Speckle-Interferometrie zum Ermitteln einer Oberflächenverspannung in einem Bereich um ein Schmelzbad, welches beim Lasersintern in einem Pulverbett erzeugt wird, ohne daraus Rückschlüsse auf sich unter der Oberfläche befindliche Materialfehler oder Materialverspannungen zu ziehen. Die ESPI wie oben beschrieben beschränkt sich auf eine Oberflächenanalyse zur Ermittlung von Verspannungen und oberflächig vorhandenen Porenbildungen oder Einschlüssen.

Die US 6 043 870 B beschreibt ein ESPI-Gerät mit kompakter Faseroptik für industrielle Anwendungen, um durch thermische Anregungen Materialanomalien und Delaminierungen zu identifizieren. Auf mögliche materialspezifische Eigenschaften und Probleme, beispielsweise Probleme durch Signale aus einem Pulverbett, wird nicht eingegangen. Auch die US 6 043 870 A beschreibt ein ESPI-System für den Einsatz in der industriellen Materialanalyse im Allgemeinen, wobei eine thermische Anregung vorgenommen wird. Wissenschaftliche Veröffentlichungen, zum Beispiel H. Gerhard, G. Busse, WCU 2003, Paris, 7.-10. September 2003, beschreiben eine Variation des ESPI mittels akustischer und thermische Anregung bei der Analyse von Polymeren und keramischen Werkstücken. Die Untersuchung dieser Anregungsmethoden sind in diesen wissenschaftlichen Publikationen auf Kunststoffe fokussiert.

Zudem werden in der Literatur Verfahren beschrieben, die eine 3D-Rekonstruktion eines Werkstücks aus thermischen Daten erlauben, zum Beispiel Fernando López Rodriguez, Vicente de Paulo Nicolau, Inverse heat transfer approach for IR image reconstruction: Application to thermal non-destructive evaluation, Applied Thermal Engineering, Vol. 33, 2012, S. 109-118, ISSN 1359-4311.

Es ist daher eine Aufgabe der vorliegenden Anmeldung, Verfahren und Vorrichtungen bereitzustellen, mit welchen eine Prüfung von mit additiven Verfahren hergestellten Werkstücken während der Herstellung möglich ist, wobei insbesondere die Besonderheiten der additiven Fertigung, insbesondere auf hohe Untergrundsignale, welche beispielsweise aus einem Pulverbett herrühren, berücksichtigt werden können.

Hierzu werden ein Verfahren nach Anspruch 1 sowie eine Vorrichtung gemäß Anspruch 9 bereitgestellt. Die Unteransprüche definieren weitere Ausführungsformen.

Gemäß einem ersten Aspekt der Erfindung wird ein Verfahren zur additiven Fertigung von Werkstücken bereitgestellt, umfassend:
Bereitstellen von Fertigungsdaten für ein Werkstück,
Simulieren der Fertigung des Werkstücks,
Simulieren von Prüfergebnissen während der Fertigung basierend auf der simulierten Fertigung,
Hinzufügen einer nächsten Gruppe von Schichten zu dem Werkstück,
Prüfen der Gruppe von Schichten um gemessene Prüfergebnisse zu erhalten ,
Auswerten des Prüfens basierend auf den simulierten Prüfergebnissen und den entsprechenden
gemessenen Prüfergebnissen,
Wiederholen des Hinzufügens, des Prüfens und des Auswertens, falls das Auswerten eine akzeptable Fertigung anzeigt, und
Ergreifen einer Maßnahme, falls das Auswerten eine inakzeptable Fertigung anzeigt,
wobei das Prüfen ein Durchführen eines Laserultraschallverfahrens umfasst,
und/oder wobei das Prüfen eine Durchführung einer elektronische Laser-Speckle-Interferometrie umfasst und /oder wobei das Prüfen ein Durchführen einer Infrarot-Thermografie umfasst und/oder wobei das Prüfen ein Durchführen einer Röntgen-untersuchung umfasst.

Durch eine derartige Kombination einer Simulation von Prüfergebnissen und einer tatsächlichen Prüfung, d.h. Messung des herzustellenden Werkstücks, kann auch für komplexere Situationen eine Abweichung aufgrund von Materialfehlern erkannt werden. Vorzugsweise wird die Fertigung des Werkstücks unter Verwendung der bereitgestellten Fertigungsdaten und unter Verwendung eines Modells zur additiven Fertigung simuliert. Besonders bevorzugt beinhaltet das Modell zur additiven Fertigung ein Modell zur Herstellung von aufeinander angeordneten und miteinander verbundenen Materialschichten, wobei die einzelnen Materialschichten beispielsweise durch Verschmelzen und/oder Verkleben von Pulverpartikeln hergestellt werden, die in einem Pulverbett angeordnet sind. Das Modell zur additiven Fertigung kann beispielsweise die Temperaturverteilung modellieren, die sich in Abhängigkeit von der Umgebungstemperatur und in Abhängigkeit von einer gezielten lokalen Energieeinstrahlung, wie etwa einer Lasereinstrahlung von einer Laserlichtquelle, in dem Pulverbett ergibt. Des Weiteren repräsentiert das Modell in den bevorzugten Ausführungsbeispiele Form und die Lage der einzelnen Materialschichten, Dimensionen, wie etwa die Länge oder Dicke ausgewählter Materialschichten und/oder deren Bindung aneinander. Vorzugsweise liefert der Schritt des Simulierens eine Repräsentation des herzustellenden Werkstücks, die in Abhängigkeit von den für die Simulation ausgewählten Fertigungsparametern, wie etwa Partikelgröße, Partikelhomogenität, Umgebungstemperatur, Bearbeitungstemperatur, Vorschubgeschwindigkeit des Werkzeugs, variiert.

Das Simulieren von Prüfergebnissen beinhaltet vorzugsweise das rechnerische Bestimmen von Parametern, die die vorgenannte Repräsentation charakterisieren. Die Prüfergebnissen können einen oder mehrere der folgenden Parameter beinhalten: Rauigkeit einer oder mehrerer Oberflächen, Welligkeit einer oder mehrerer Oberflächen, Form einer oder mehrerer Oberflächen, Dimensionen wie Abstand, Durchmesser, Umfang von ausgewählten Werkstückbereichen, Temperatur oder Temperaturverteilung an ausgewählten simulierten Messpunkten sowie das Vorhandensein und ggf. die Dimension von Poren, Rissen, Materialeinschlüssen u.a.. Mit anderen Worten wird hier eine simulierte Messung an dem simuliert hergestellten Werkstück rechnerisch durchgeführt, um individuelle Eigenschaften des simuliert hergestellten Werkstücks zu bestimmen. Es versteht sich, dass diese individuellen Eigenschaften in Abhängigkeit von den für die Simulation gewählten Fertigungsparametern variieren. Andererseits repräsentieren die individuellen Eigenschaften des simuliert hergestellten Werkstücks ein Referenzwerkstück für das real hergestellte Werkstück.

Das Hinzufügen einer nächsten Gruppe von Schichten beinhalten, dass unter Verwendung eines additiven Fertigungsverfahrens eine neue Werkstückschicht "real" auf bereits vorhandenen Werkstückschichten aufgebracht wird. In bevorzugten Ausführungsbeispielen erfolgt dies, wie oben angedeutet, durch Verschmelzen und/oder Verkleben von Pulverpartikeln, die auf bereits vorhandenen Werkstückschichten angeordnet werden.

Der Schritt des Prüfens beinhaltet das Bestimmen von individuellen Parametern, die die neue Werkstückschicht zusammen mit den darunter liegenden Werkstückschichten charakterisieren. Die individuellen Parameter können einen oder mehrere der folgenden Parameter beinhalten: Rauigkeit einer oder mehrerer Oberflächen, Welligkeit einer oder mehrerer Oberflächen, Form einer oder mehrerer Oberflächen, Dimensionen wie Abstand, Durchmesser, Umfang von ausgewählten Werkstückbereichen, Temperatur oder Temperaturverteilung an ausgewählten Messpunkten und ggf. die Dimension von Poren, Rissen, Materialeinschlüssen u.a.. Die Messung kann die Anregung der neuen Werkstückschicht zusammen mit den darunter liegenden Werkstückschichten mit Hilfe einer Energiequelle sowie die Messung von Reflexionen, Transmission oder Streuung der Energiestrahlung an den Werkstückschichten beinhalten. Die Energie kann mit Hilfe von Röntgenstrahlung, UV-Strahlung, IR-Strahlung, sichtbarer Lichtstrahlung und/oder mit Schall einschließlich Ultraschall auf die Werkstückschichten gebracht werden.

Das Auswerten kann ein Auswerten unter Verwendung eines mittels maschinellen Lernens trainierten Systems umfassen. Dabei kann mittels Trainingsbeispielen ein Lernen erfolgen, was das Auswerten erleichtert.

Das Auswerten kann ein Vergleichen der simulierten Prüfergebnisse mit den gemessenen Prüfergebnissen umfassen. So kann beispielsweise ein Anteil eines Pulverbetts herausgerechnet werden. Insbesondere beinhaltet der Schritt des Auswertens einen Vergleich der individuellen Parameter der vorgenannten Repräsentation und der jeweils entsprechenden individuellen Parameter der neuen Werkstückschicht zusammen mit den jeweils darunter liegenden Werkstückschichten. Dementsprechend beinhaltet des neue Verfahren in einigen Ausführungsbeispielen einen schichtweisen Vergleich von durch Simulation bestimmten Parametern und durch Messung bestimmten Parametern. Das durch additive Fertigung hergestellte Werkstück wird vorzugsweise zwischen der Herstellung einzelner Werkstückschichten mit einer durch Simulation bestimmten erwarteten Werkstückstruktur verglichen. Die durch Simulation bestimmten Parameter repräsentieren Werkstückschichten, die unter idealen, modellhaften Bedingungen entstehen. Die im Schritt des Prüfens bestimmten individuellen Parameter repräsentieren das reale Herstellungsergebnis. Durch einen Vergleich der jeweiligen Parameter können Abweichungen des Fertigungsprozesses vom idealen Fertigungsprozess auf effiziente Weise erkannt werden.

Das Ergreifen einer Maßnahme kann ein Ändern von Prozessparametern für ein folgendes Hinzufügen einer Gruppe von Schichten umfassen. Dies kann ein Hinzufügen für ein nächstes zu fertigendes Werkstück oder für das gleiche Werkstück sein. So kann das Auswerten zur Prozessverbesserung benutzt werden.

Das Ergreifen einer Maßnahme kann auch ein Verwerfen des Werkstücks umfassen, wenn zum Beispiel das Auswerten ergibt, dass das Werkstück wegen Materialfehlern Qualitätsanforderungen nicht genügt.

Die Gruppe von Schichten kann eine einzige Schicht, mehrere Schichten oder einen Teil einer Schicht umfassen. Je nach Anforderungen kann das Prüfen und Auswerten also verschieden häufig durchgeführt werden.

Das Auswerten kann eine Verwendung einer vorgegebenen Korrelation von Unterschieden zwischen den gemessenen Prüfergebnissen und den simulierten Prüfergebnissen zu Bauteileigenschaften umfassen. Es können also beispielsweise aus Kalibriermessungen derartige Korrelationen bestimmt werden und dann auf das Auswerten angewendet werden.

Das Prüfen kann eine Durchführung eines Laserultraschallverfahrens umfassen. Dabei wird bei einem Pulverbettverfahren bevorzugt ein Laserstrahl mit einer Pulsfrequenz unterhalb von fₘₐₓ = v_{M}/(d_{M} + s_{M}) verwendet, wobei v_{M} die Schallgeschwindigkeit im homogenen Pulvermaterial und d_{M} ein mittlerer Partikeldurchmesser des Pulvers und s_{M} eine einfache Standardabweichung der Größenverteilung der Partikel ist.

Das Prüfen kann auch eine Durchführung einer elektronischen Laser-Speckle-Interferometrie umfassen.

Das Prüfen kann auch eine Durchführung einer Infrarot-Thermografie oder einer Röntgen-Untersuchung, beispielsweise Röntgen-Scatterometrie, umfassen.

Durch die Verwendung einer Simulation können auch komplexe Messdaten aus diesen Verfahren ausgewertet werden.

Gemäß einem zweiten Aspekt wird eine Vorrichtung zur additiven Fertigung von Werkstücken bereitgestellt, umfassend:
eine Simulationseinrichtung zum Simulieren einer additiven Fertigung eines Werkstücks und zum Simulieren von Prüfergebnissen während der Fertigung,
eine Fertigungseinrichtung zum additiven Fertigen des Werkstücks, und
eine Prüfeinrichtung zum Prüfen des Werkstücks während der additiven Fertigung, um gemessene Prüfergebnisse zu erlangen,
wobei die Prüfeinrichtung eingerichtet ist, das Werkstück jeweils nach dem Hinzufügen einer nächsten Gruppe von Schichten zu prüfen, und die Simulationseinrichtung eingerichtet ist, ein Auswerten auf Basis der simulierten Prüfergebnisse und der gemessenen Prüfergebnisse durchzuführen und zu bewirken, dass eine Maßnahme ergriffen wird, wenn das Auswerten eine inakzeptable Fertigung des Werkstücks anzeigt.

Die Prüfeinrichtung umfasst dabei eine Laserultraschallprüfeinrichtung, eine elektronische Laser-Speckle-Interferometrieprüfeinrichtung, eine Infrarot-Thermografieprüfeinrichtung und/oder eine Röntgen-Untersuchungseinrichtung.

Die Erfindung wird nachfolgend anhand von verschiedenen Ausführungsbeispielen ausführlich erläutert. Es zeigen:
Figuren 1A und 1B Beispiele für Materialfehler bei additiver Fertigung,
Figur 2 ein Beispiel für Materialfehler bei einem Pulverbettverfahren zur additiven Fertigung,
Figur 3 ein Flussdiagramm zur Veranschaulichung eines Verfahrens gemäß einem Ausführungsbeispiel,
Figur 4 eine Darstellung zur Veranschaulichung der Verwendung von Simulationen in manchen Ausführungsbeispielen,
Figur 5 eine Vorrichtung zur Durchführung eines laserultraschallbasierten Prüfens eines Werkstücks gemäß einem Ausführungsbeispiel,
Figur 6 ein Flussdiagramm eines Verfahrens gemäß einem Ausführungsbeispiel,
Figur 7 eine Vorrichtung zum Prüfen eines Werkstücks gemäß einem Ausführungsbeispiel, und
Figur 8 eine Vorrichtung zum Prüfen eines Werkstücks gemäß einem weiteren Ausführungsbeispiel.

Nachfolgend werden verschiedene Ausführungsbeispiele detailliert erläutert. Diese Ausführungsbeispiele dienen lediglich der Veranschaulichung und sind nicht als einschränkend auszulegen. So weisen manche beschriebenen Ausführungsbeispiele eine Vielzahl von Merkmalen oder Komponenten auf. Dies ist nicht dahingehend auszulegen, dass alle diese Merkmale oder Komponenten zur Implementierung notwendig sind. Vielmehr können andere Ausführungsbeispiele weniger Komponenten oder Merkmale oder auch alternative Merkmale oder Komponenten aufweisen. Zusätzlich zu den explizit dargestellten und beschriebenen Merkmalen und Komponenten können auch weitere Merkmale oder Komponenten, insbesondere Merkmale oder Komponenten herkömmlicher Systeme zur additiven Fertigung oder zur Analyse von Werkstücken, bereitgestellt sein.

Merkmale verschiedener Ausführungsbeispiele können miteinander kombiniert werden, sofern nichts anderes angegeben ist. Variationen und Abwandlungen, welche für eines der Ausführungsbeispiele beschrieben werden, sind auch auf andere Ausführungsbeispiele anwendbar.

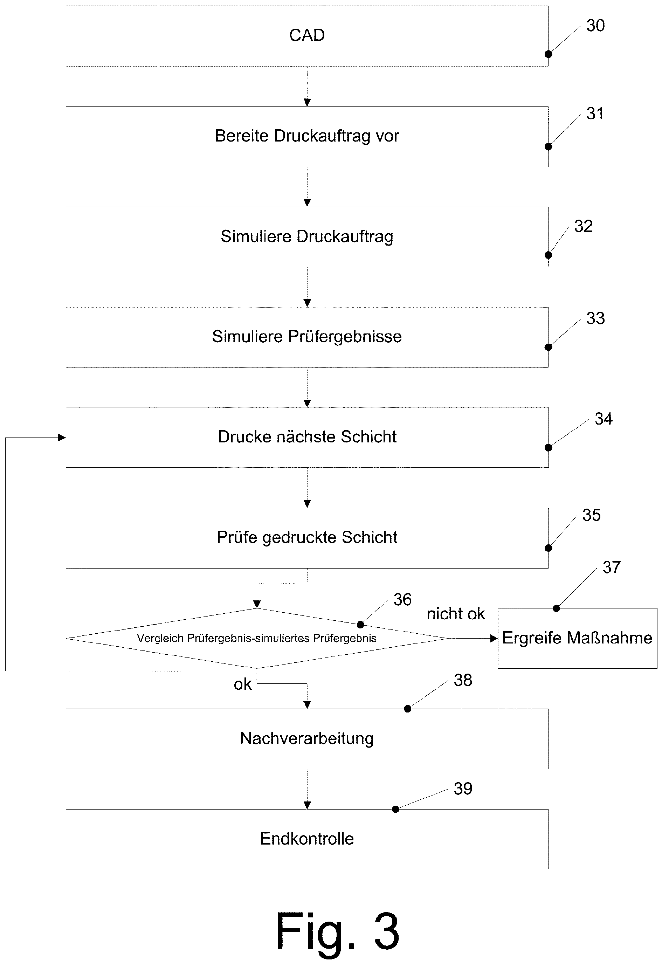

Die Figur 3 zeigt ein Flussdiagramm eines Verfahrens zum additiven Herstellen eines Werkstücks gemäß einem Ausführungsbeispiel. Eine derartige additive Fertigung wird nachfolgend auch als 3D-Druck oder kurz als Druck bezeichnet. Als Verfahren zur Herstellung können dabei pulverbettbasierte Verfahren wie beispielsweise Lasersintern oder auch Verfahren, bei denen ein Pulver, insbesondere Metallpulver, durch ein Bindemittel schichtweise verfestigt wird, zum Einsatz kommen. Dieses und folgende Ausführungsbeispiele sind jedoch auch auf andere Herstellungsverfahren als pulverbettbasierte Verfahren anwendbar.

Bei dem Verfahren wird in Schritt 30 ein computergestützter Entwurf (CAD, vom englischen computer aided design) eines Werkstücks bereitgestellt. In Schritt 31 wird dann ein Druckauftrag vorbereitet, indem der computergestützte Entwurf aus Schritt 30 in Anweisungen für eine bestimmte Vorrichtung zum 3D-Druck, beispielsweise eine pulverbettbasierte Vorrichtung wie eingangs unter Bezugnahme auf Fig. 2 erläutert, umgewandelt wird.

In Schritt 32 wird dann der Druckauftrag simuliert, d.h. das Herstellen des Werkstücks wird Schicht für Schicht inklusive des umgebenden Pulverbetts simuliert. In Schritt 33 werden dann Prüfergebnisse für den jeweiligen Stand der Herstellung, d.h. nach einer jeweiligen Anzahl von aufgetragenen Schichten, simuliert, d.h. Messergebnisse eines Messverfahrens, welches zum Prüfen des Werkstücks verwendet wird, werden simuliert. Derartige Messverfahren können, wie später erläutert werden wird, beispielsweise ultraschallbasierte Verfahren, thermographische Verfahren, Röntgen-Scatterometrie und/oder interferometrische Verfahren wie die elektronische Laser-Speckle-Interferometrie umfassen.

Die Schritte 32 und 33 stellen also eine Simulation einer Herstellung eines fehlerfreien Werkstücks dar, und die in Schritt 33 erhaltenen Prüfergebnisse entsprechen simulierten Prüfergebnissen für ein fehlerfreies Werkstück.

In Schritt 34 beginnt dann der eigentliche additive Herstellungsprozess mit dem Drucken einer nächsten anstehenden Schicht (beim ersten Durchlauf des Schrittes 34 der ersten Schicht). In Schritt 35 wird dann die bei 34 gedruckte Schicht mit einem Messverfahren geprüft, für welches in Schritt 33 auch die Simulation durchgeführt wurde. In Schritt 36 wird dann das Prüfergebnis des Schrittes 35 mit dem simulierten Prüfergebnis des Schrittes 33 verglichen. Indem hier sowohl eine Simulation eines fehlerfreien Druckes als auch eine tatsächliche Prüfung erfolgt und die Ergebnisse verglichen werden, können beispielsweise Effekte von einem Untergrund wie beispielsweise durch ein Pulverbett wie eingangs erläutert gleich herausgerechnet werden, und Signalanteile, die von Materialdefekten herrühren, können leichter identifiziert werden. Es können also Störeinflüsse, die sich aus dem Prozess der additiven Fertigung ergeben, auch bei großen Datenmengen aus den Prüfmessungen herausgefiltert werden.

Das Vergleichen des Schrittes 36 kann dabei ein einfaches Subtrahieren von jeweiligen Signalen umfassen. Bevorzugt wird jedoch ein Analysesystem zunächst trainiert und führt dann den Vergleich durch, um nähere Informationen über vorliegende Defekte zu erhalten. Hierzu können insbesondere Verfahren des maschinellen Lernens verwendet werden, zum Beispiel zum Trainieren eines künstlichen neuronalen Netzwerkes. Verfahren des maschinellen Lernens sind in dem Wikipedia-Artikel "Maschinelles Lernen, Stand 27.09.2017, beschrieben. Hierfür werden in einem Lernprozess die gefertigten Werkstücke dann mit anderen Messverfahren analysiert, die auch zerstörende Verfahren sein können. Beispielsweise können Schnitte des hergestellten Werkstücks mikroskopisch, einschließlich elektronenmikroskopisch, untersucht werden, um verschiedene Materialdefekte zu identifizieren. Diese identifizierten Merkmale werden dann zusammen mit den in Schritt 35 ermittelten Ergebnissen der tatsächlichen Messung und der in Schritt 33 simulierten Prüfergebnisse als Trainingsbeispiele für das maschinelle Lernen verwendet. Während der tatsächlichen Herstellung kann ein so trainiertes System dann in Schritt 36 auf Basis des Prüfergebnisses des Schritts 35 und der simulierten Prüfergebnisse des Schritts 33 genauere Aussagen über vorhandene Materialdefekte machen. Für das maschinelle Lernen können beispielsweise Verfahren des bestärkenden Lernens (Reinforcement Learning), oder andere Lernverfahren verwendet werden. Bei anderen Ausführungsformen können zusätzlich oder alternativ Korrelationsanalysen zwischen den Ergebnissen des Schrittes 35 und den Simulationsergebnissen des Schrittes 33 vorgenommen werden.

Wenn der Vergleich in Schritt 36 ergibt, dass inakzeptable Fehler vorliegen (nicht okay in Schritt 36; inakzeptable Fertigung), beispielsweise eine zu hohe Anzahl von Materialdefekten oder zu große Materialdefekte, können in Schritt 37 entsprechende Maßnahmen ergriffen werden. Eine derartige Maßnahme kann beispielsweise ein Verwerfen des gerade hergestellten Werkstücks sein, kann aber zusätzlich oder alternativ auch ein Anpassen von Prozessparametern umfassen, um bei einer nächsten Schicht weniger Materialdefekte zu erzeugen. Durch die Anpassung von Prozessparametern in Schritt 39 während des Prozesses kann ein Bauteil gegebenenfalls noch "gerettet werden", indem Fehler auf eine Schicht beschränkt werden können, was noch zu akzeptablen Werkstücken führen kann, je nach Erfordernissen an das Werkstück. Auch kann je nach Fertigungsverfahren eine Prozessierung einer Schicht, bei der zu viele Materialfehler aufgetreten sind, wiederholt werden. Hierfür wird die fehlerhafte Schicht abgetragen und mit korrigierten Prozessparametern erneut aufgetragen. Hier ist also eine Korrektur während des Herstellungsprozesses und/oder für folgende Herstellungsprozesse möglich. Derartige Herangehensweisen bei der Korrektur werden auch als holistisch bezeichnet, da hier nicht unbedingt die Ursache der Störung behoben wird, sondern die Auswirkung (zum Beispiel Materialdefekte) erkannt wird und durch eine Gegenwirkung, beispielsweise durch Ändern von Prozessparametern, kompensiert wird. Für die Korrektur können weitere dezidierte numerische Korrelationsanalysen bei der Simulation durchgeführt werden. Insbesondere können dabei auch gemessene Maschinenparameter und die Daten weiterer Sensoren z.B. zur Überwachung der Umweltbedingungen berücksichtigt werden, indem z.B. eine Korrelation zwischen den Messergebnissen und den Sensordaten durchgeführt wird. Außerdem kann z.B. die Auswirkung der Korrektur vor dem eigentlichen additiven Fertigungsprozess simuliert werden. Diese Simulation kann Teil eines Optimierungsalgorithmus sein, um einen optimalen Korrekturprozess zu bestimmen.

Zum Vergleichen in Schritt 36 kann auch eine vorgegebene "Übersetzungstabelle" herangezogen werden, welche auf Basis von vorherigen Kalibrierungen (Analysen von Werkstücken, beispielsweise zerstörungsbehaftete Analyse) eine Korrelation zwischen Unterschieden zwischen Simulation und tatsächlichem Prüfen und Baueigenschaften des Werkstücks angibt.

Wenn der Vergleich bei 36 hingegen ergibt, dass die Schicht nach Qualitätserfordernissen in Ordnung ist (beispielsweise hinreichend wenig Materialdefekte vorliegen; akzeptable Fertigung), wird entweder zu Schritt 34 zurückgesprungen, um eine nächste Schicht zu drucken, oder, wenn keine weitere Schicht zu drucken ist, d.h. der Druck abgeschlossen ist, in Schritt 38 eine etwaig notwendige Nachverarbeitung des Werkstücks (beispielsweise Reinigen von haftendem Pulver, Polieren etc.) durchgeführt. In Schritt 39 kann dann noch eine Endkontrolle des hergestellten Werkstücks erfolgen.

Mit dem Verfahren der Figur 3 kann also jede gedruckte Schicht überwacht werden und anhand von Simulationen können auch komplexe Messsignaturen beim Prüfen analysiert werden.

Es ist zu bemerken, dass bei anderen Ausführungsformen das Prüfen und der Vergleich des Prüfergebnisses mit dem simulierten Prüfergebnis nicht nach jeder Schicht, sondern auch im Abstand mehrerer Schichten (beispielsweise jede zweite Schicht, jede dritte Schicht etc.) oder auch für Teile von Schichten vorgenommen werden kann. Zudem ist zu bemerken, dass das Simulieren nicht wie in Figur 3 dargestellt vor dem Drucken erfolgen muss, sondern auch gleichzeitig mit diesem erfolgen kann, sodass zum Beispiel beim, vor oder nach dem Drucken jeder Schicht in Schritt 34 das Drucken der jeweiligen Schicht auch simuliert wird und die entsprechenden Prüfergebnisse simuliert werden. Die in Figur 3 dargestellte Reihenfolge dient daher nur der Veranschaulichung und ist nicht als einschränkend zu sehen.

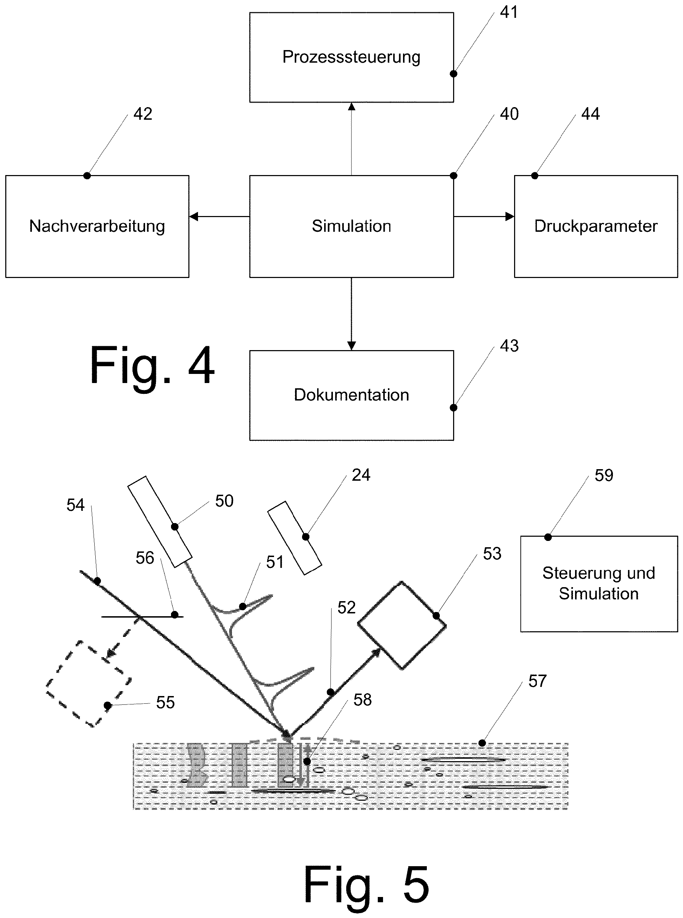

Zusätzlich zu der Überwachung des Herstellungsprozesses wie in Fig. 3 dargestellt kann die Simulation des Wachstumsprozesses und der Messungen auch noch für weitere Zwecke verwendet werden. Dies ist in Fig. 4 schematisch dargestellt.

Ausgehend von einer Simulation eines Herstellungsprozesses 40, welcher das Simulieren der Schritte 32 und 33 der Fig. 4 umfassen kann, können verschiedene weitere Vorgänge gesteuert, dokumentiert oder ausgeführt werden. In die Simulation bei 40 können dabei Kalibrierdaten der verwendeten Vorrichtung zur additiven Fertigung, und des Pulverbettes ebenso wie die bereits schon erwähnten für das Drucken aufbereiteten CAD-Daten eingehen.

Bei 41 wird die Prozesssteuerung wie unter Fig. 3 erläutert durchgeführt, d.h. es werden Prüfergebnisse während des Prozesses mit der Simulation verglichen und entsprechende Ausgaben vorgenommen. Zudem können bei 42 Hinweise für die Nachverarbeitung in Schritt 38 der Fig. 3 auf Basis der Simulation gegeben werden. Bei 43 kann auf Basis der Simulation eine Dokumentation erstellt werden, beispielsweise in Form einer CAD-Datei des gefertigten Bauteils, gegebenenfalls unter Berücksichtigung der Nachverarbeitung. Schließlich können bei 44, wie bereits eingangs erläutert und wie für sich genommen bekannt, Druckparameter optimiert werden.

Ein Beispiel für ein Prüfverfahren, welches in dem Verfahren der Fig. 3 zur Anwendung kommen kann, ist eine Laser-Ultraschallmessung. Eine solche Messung wird unter Bezugnahme auf Fig. 5 erläutert. Die Vorrichtung der Fig. 5 dient zum schichtweisen Prüfen eines Werkstücks 57, welches mit einem additiven Verfahren, beispielsweise einem Pulverbettverfahren, hergestellt werden kann. Als additives Verfahren können konventionelle Techniken zur additiven Fertigung zum Einsatz kommen. Diese Fertigung ist in Fig. 5 durch den Laser 24 zum Lasersintern, der unter Bezugnahme auf Fig. 2 beschrieben wurde, angedeutet. Die Fertigung sowie das Prüfen wird von einer Steuereinrichtung 59, insbesondere einem Computer oder einer anderen geeigneten Steuerung, überwacht. Die Steuerung 59 führt bei dem Ausführungsbeispiel der Fig. 5 auch die Simulationen (Schritte 32 und 33 der Fig. 3) durch und vergleicht die Prüfergebnisse mit den simulierten Prüfergebnissen (Schritt 36 der Fig. 3). Es können jedoch auch separate Vorrichtungen, beispielsweise separate Computer, für Steuerung und Simulation bereitgestellt werden.

Bei dem Ausführungsbeispiel der Fig. 5 wird die Oberfläche des Werkstücks 57 zur Prüfung einer oder mehrerer Schichten oder Teilen davon mittels eines Kurzpulslasers 50 mit einem gepulsten Laserstrahl 51 bestrahlt, welcher im Femtosekunden- bis Pikosekundenbereich gepulst ist. Der Laserstrahl 51 wird dabei durch eine (nicht dargestellte) geeignete Optik auf das Werkstück fokussiert und mittels einer Scaneinheit (ebenfalls nicht dargestellt) über die Oberfläche des Werkstücks 57 gescannt. Der Laserstrahl 51 induziert Schallwellen, welche wie durch Pfeile 58 dargestellt an Materialdefekten reflektiert werden und eine Änderung der (insbesondere Deformation) der Oberfläche des Werkstücks bewirken. Diese Änderung wird durch ein Detektorsystem, beispielsweise ein Homodyn-Interferometer oder ein Heterodyn-Interferometer, nachgewiesen. Dies ist schematisch durch einen Detektionsstrahl 54, welcher auf die Probe trifft, dargestellt. Mit einem Detektor 53 wird ein vorwärtsreflektierter Strahl 52 nachgewiesen. Alternativ oder zusätzlich wird über einen Detektor 45 ein rückwärtsreflektierter Strahl, welcher über einen Strahlteiler 56 ausgekoppelt wird, detektiert. Jeder bei Laser-Ultraschallvorrichtungen verwendete herkömmliche Detektionsmechanismus kann hier verwendet werden, siehe hierzu die eingangs zitierten Dokumente zum Laser-Ultraschall.

Für typische Schallgeschwindigkeiten, die bei Teflon beispielsweise 1400 m/s und bei Titan 6100 m/s betragen, ergibt sich für eine maximal abbildbare Strukturtiefe von 0,5 mm eine Pulslaufzeit von Δt = 2d/c_{sound} vom 0,2 bis 1 µs, wobei d die Strukturtiefe und c_{sound} die Schallgeschwindigkeit ist. Das bedeutet, dass mit einem im Megahertzbereich arbeitenden Scansystem 1000 · 1000 Pixel über typische betrachtete Flächen abgebildet werden können. Die Gesamtfläche kann größer sein, wenn der Scanbereich auf einen entsprechend kleineren interessierenden Bereich eingeschränkt wird. Für eine Tiefenauflösung von 1 µm ist eine Zeitauflösung der Detektion im Gigahertzbereich notwendig, was mit heute verwendeten Laser-Doppler-Vibrometern möglich ist.

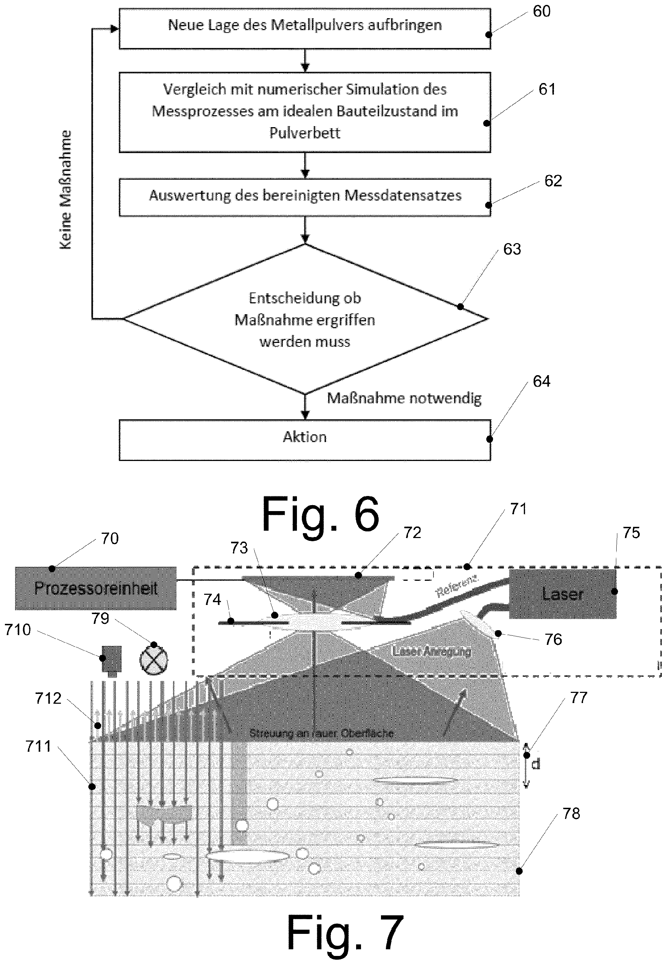

Die gefundenen Messergebnisse (durch die Detektoren 53 und/oder 55 detektiert) werden dann wie beschrieben schichtweise mit entsprechenden Simulationen verglichen und ausgewertet. Dies ist für den Fall einer Pulverbettfertigung in der Fig. 6 nochmals erläutert. Fig. 6 zeigt also eine Anwendung des Verfahrens der Fig. 3 auf eine Pulverbettfertigung und der Verwendung von Laser-Ultraschall.

In Schritt 60 wird eine neue Lage eines Metallpulvers aufgebracht, insbesondere verfestigt. Dann wird eine Laser-Ultraschallmessung durchgeführt und das Messergebnis in Schritt 61 mit einer numerischen Simulation des Messprozesses an einem idealen (fehlerfreien) Zustand des Werkstücks im Pulverbett durchgeführt. Hieraus wird ein bereinigter Messdatensatz erhalten, indem beispielsweise auf Basis der Simulation von dem Pulverbett herrührender Untergrund herausgerechnet wird. Auf Basis der Auswertung wird in Schritt 63 entschieden, ob eine Maßnahme ergriffen werden muss. Wenn keine Maßnahme notwendig ist, wird das Verfahren in Schritt 60 mit der nächsten Lage fortgesetzt. Falls eine Maßnahme ergriffen werden muss, erfolgt dies in Schritt 64. Dabei können die bereits unter Bezugnahme auf Schritt 37 der Fig. 3 diskutierten Maßnahmen ergriffen werden.

Bevorzugt wird für die Messung eine Schallwellenlänge (induziert durch den Kurzpulslaser) verwendet, deren Wellenlänge in dem Material, aus dem das Pulver gefertigt ist, deutlich größer ist als der mittlere Pulverkorndurchmesser. Damit können insbesondere Defekte, die größer sind als die Korndurchmesser, detektiert werden und auch die geometrischen Abmessungen des Werkstücks detektiert werden. Für ein Pulver aus einem Material M mit einer Schallgeschwindigkeit v_{M} im homogenen Material und einer Partikelgrößenverteilung gekennzeichnet durch einen mittleren Partikeldurchmesser (Pulverkorndurchmesser) von d_{M} und einer einfachen Standardabweichung der Größenverteilung der Pulverkörner von s_{M} wird bevorzugt ein Kurzpulslaser mit einer maximalen Frequenz fₘₐₓ < v_{M}/(d_{M} + s_{M}) verwendet. Als Beispiel bedeutet dies für ein Titanpulver mit 20 µm Korngröße und 5 µm Standardabweichung wegen der Schallgeschwindigkeit von 6100 m/s eine maximale Frequenz von 244 MHz.

Sämtliche angegebenen Zahlenwerte sind dabei lediglich zur Veranschaulichung angegeben und können insbesondere je nach verwendeten Materialien und Messverfahren variieren.

Ein weiteres Beispiel für ein Prüfverfahren, welches in Schritt 35 der Fig. 3 verwendbar ist, ist eine Kombination einer elektronischen Speckle-Interferometrie (ESPI) mit einer Infrarot-Thermografie. Die ESPI ist in der Lage, die Oberflächentopografie des zu prüfenden Werkstücks zu detektieren. Durch die kombinierte Anregung mittels Infrarotthermografie können Poren, Risse, Lunkern, Delaminationen (Schichtablösungen) und andere sich unter der Oberfläche befindliche Defekte im Werkstück analysiert werden. Die Kombination beider Prüfverfahren erlaubt somit eine schnelle flächenhafte Analyse der in Fertigung befindlichen Schichten. Durch die ESPI kann insbesondere auch die Topografie des Schmelzbades beim Verwenden eines Lasersinterns charakterisiert werden, während durch die Infrarot-Thermografie eine derzeit gedruckte Schicht oder eine Gruppe von Schichten auf Defekte analysiert wird. Die Analyse erfolgt dann bei Verwendung des Verfahrens der Fig. 3 wiederum durch Abgleich mit einer Simulation, wobei insbesondere wie erläutert auch maschinelle Lernverfahren zum Einsatz kommen können, um eine Analyse zu ermöglichen. Auch eine Prüfung, nachdem nur ein Teil einer Schicht gedruckt wurde, ist möglich. ES-PI hat den Vorteil, dass parallel das Pulverbett durch ESPI auf Änderungen während des Druckprozesses überwacht werden kann.

Die Fig. 7 veranschaulicht eine Vorrichtung zur Durchführung einer kombinierten ESPI mit Infrarot-Thermografie eines mit einem additiven Fertigungsverfahren hergestellten Werkstücks 78. Das Werkstück 78 kann beispielsweise mittels eines Pulverbettverfahrens wie beispielsweise Lasersintern hergestellt werden, wie es unter Bezugnahme auf Fig. 2 kurz beschrieben wurde und wie es auch in Fig. 5 angedeutet ist.

Auch andere herkömmliche additive Fertigungsverfahren sind verwendbar. Daher sind in Fig. 7 diejenigen Komponenten, welche für die additive Fertigung selbst verwendet werden, nicht explizit dargestellt.

Zur ESPI weist die Vorrichtung der Fig. 7 eine ESPI-Kamera 71 auf. Diese umfasst einen Laser 75. Ein Teil des vom Laser 75 erzeugten Laserstrahls wird über eine Optik 76 aufgeweitet und auf eine Oberfläche des Werkstücks 78 gelenkt.

Von der Oberfläche, insbesondere Rauigkeiten an der Oberfläche, gestreutes Licht gelangt über eine Abbildungsoptik 73, welche durch eine Blende 74 begrenzt sein kann, zu einem Bildsensor 72. Der Bildsensor 72 kann beispielsweise ein CCD-Sensor oder ein CMOS-Sensor sein.

Zusätzlich wird ein Teil des von dem Laser 75 erzeugten Laserlicht als Referenz auf den Bildsensor 17 gelenkt und interferiert dort mit dem von der Oberfläche des Werkstücks 78 gestreuten Lichts. Der Bildsensor 72 nimmt das entstehende Interferenzmuster auf und führt es einer Prozessoreinheit 70 zu, welche das aufgenommene Interferenzbild analysiert, insbesondere mit einer Simulation vergleicht und gegebenenfalls auf Basis eines vorherigen maschinellen Lernens analysiert.

Insbesondere entsteht durch die Interferenz ein charakteristisches Speckle-Muster, welches durch Manipulationen der Oberfläche des Werkstücks 78 durch Verformungen, Partikel, Defekte etc. von einer Ursprungsform abweicht. Während einer kontrollierten Manipulation des Werkstücks werden nun ohne Änderung der relativen Position von Werkstück 78 und ESPI-Kamera 71 aufeinanderfolgende Bilder aufgenommen. Die Manipulation kann dabei insbesondere durch parallele IR-Thermografie wie folgend beschrieben erfolgen. Diese Manipulation führt zu kleinen Verformungen des Objekts und lässt dabei Speckle-Punkte auf den aufgenommenen Interferenzmustern wandern. Die Analyse durch die Prozessoreinheit 70 kann dann durch die Manipulation hervorgerufene Verformungen analysieren und dadurch insbesondere Oberflächendefekte des Werkstücks 78 identifizieren.

Zur IR-Thermografie wird das Werkstück 78 mit einer Wärmequelle 79, beispielsweise einer Infrarotlampe, bestrahlt, und eine Infrarotstrahlungsverteilung an der Oberfläche wird über eine Infrarotkamera 710 aufgenommen. Das Bild der Infrarotkamera 710 wird ebenso in der beschriebenen Weise, d. h. mittels Vergleich mit Simulationen, durch die Prozessoreinheit 70 ausgewertet. Mittels der Infrarot-Thermografie können oberflächennahe Defekte schnell detektiert werden. Wie durch Pfeile 711 angedeutet, kommt es durch Poren, Risse, Lunker, Delaminationen und dergleichen zu einem inhomogenen Wärmefluss innerhalb des Werkstücks 78. Dies führt zu Änderungen in der Abstrahlung von Infrarotstrahlung, wie durch Pfeile 712 angedeutet. Ein Defekt ist dabei nur in einem gewissen Zeitfenster während der Fertigung sichtbar. Zu einer bestimmten Zeit tmax tritt ein maximaler thermischer Kontrast dTmax=T2-T1 aus, wobei T2, T1 Temperaturen sind. Das Zeitfenster wird durch die Abkühlzeit für das beobachtete Oberflächenelement bestimmt: Die eingebrachte Wärme, die zu einer erhöhten Temperatur des Oberflächenelementes geführt hat, fließt durch die Wärmeleitfähigkeit des restlichen Werkstücks, des Pulverbettes, des Schutzgases darüber, sowie durch Wärmestrahlung ab. Die so entstehende thermische Emission ist eine materialspezifische Kenngröße.

Diese Temperaturunterschiede, d.h. die thermische Emission, werden mit der Infrarotkamera 710 erfasst und ausgewertet. Von der erfassten thermischen Emission wird dann ein entsprechender materialspezifischer Emissionsparameter (dieser kann zwischen Poren, Einschlüssen, Metalloxide, etc. stark variieren, ) abgezogen. Aus dieser Differenz kann ich die Art und Lage des Defektes ermitteln.

Als Anregungsquelle 79 kann beispielsweise ein Laser, eine Leuchtdiodenanordnung, ein Blitzlicht oder ein Infrarotstrahler dienen. Bei manchen Ausführungsbeispielen arbeitet die Anregungsquelle 79 gepulst (in Pulsthermografie), d. h. die Wärme wird impulsartig in die Oberfläche eingeprägt und synchron das Infrarotbild der Oberfläche gemessen.

Durch die Infrarot-Thermografie kann das Werkstück 78 beispielsweise bis zu einer Tiefe d, wie durch einen Pfeil 77 angedeutet, zuverlässig auf Defekte untersucht werden. Wie bei anderen dargestellten Prüfverfahren kann die Untersuchung bei oder nach jeder Schicht, bei oder nach mehreren Schichten oder auch Teilschichten vorgenommen werden.

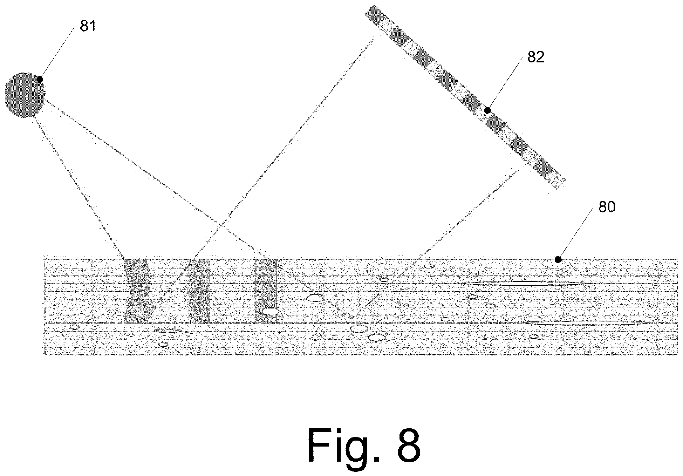

Ein weiteres Beispiel für ein Prüfverfahren während des 3D-Drucks ist die Nutzung von Röntgenstrahlung. In der konventionellen Computer-Tomographie (CRT) wird das Werkstück vollständig durchstrahlt und ein Bild im Schattenwurf, genannt Projektion, erstellt und aus der Kombination mehrerer Projektionen durch mathematische Verfahren wie der Radon-Transformation ein dreidimensionales Modell des untersuchten Objektes rekonstruiert. Dieses Verfahren kann für die in-situ Kontrolle während des 3D-Drucks für leichte Materialien wie Kunststoffe verwendet werden. Für dichte Materialien wie Stahl reicht in der Regel die Durchdringungsfähigkeit der Röntgenstrahlung nicht aus. Hier können Verfahren in Reflexion eingesetzt werden, z.B. Röntgen-Scatterometrie, wofür ein Beispiel in Figur 8 dargestellt ist. In Figur 8 sind Komponenten zum Fertigen eines Werkstücks 80 nicht dargestellt (z.B. der Laser 24 der Fig. 2 oder 5), es können herkömmliche additive Fertigungsverfahren zum Einsatz kommen. Das Werkstück 80 wird von einer Röntgenquelle 81 mit Röntgenstrahlung beleuchtet und die am Werkstück 80 gestreute Strahlung (z.B. durch elastische Streuung oder Compton-Streuung gestreute Strahlung) wird mit einem flächigen Detektor 82 erfasst. Wie bei den vorherigen Ausführungsbeispielen wird das Messergebnis zudem simuliert, und auf Basis des simulierten und tatsächlichen Messergebnisses können Materialdefekte erfasst werden.

Ein limitierender Aspekt dieser Messtechnik ist der notwendige Ausgleich aus Teilegröße und Bildauflösung: Für große Teile wird hochenergetische Röntgenstrahlung benötigt, die zu einer verschlechterten räumlichen Auflösung führt. Kleine Teile können dagegen mit hoher Auflösung mit Röntgenstrahlung mit niedriger Energie abgebildet werden. Eine hohe Energie ist hier z.B. Röntgenstrahlung mit 100eV Photonenenergie. Niedrige Energie liegt z.B. bei 10eV Photonenenergie.

Zur Auswertung werden die Messergebnisse mit den beschriebenen Verfahren, insbesondere Vergleich mit einer Simulation und/oder mit Verfahren des maschinellen Lernens analysiert. Hierdurch können insbesondere die großen Datenmengen, die bei diesem Messverfahren entstehen, abgeglichen werden, um dadurch Störeinflüsse bedingt aus dem Prozess der additiven Fertigung herauszufiltern. Ein solcher Ansatz des maschinellen Lernens lässt sich mit anderen algorithmischen Verfahren kombinieren, die aus den gemessenen Daten eine direkte Rekonstruktion erlauben. Eine solche Kombination aus mehreren Auswerteverfahren kann eine verbesserte Auflösung und/oder ein verbessertes Signalrauschverhältnis ergeben.

## Patentansprüche

1. Verfahren zur additiven Fertigung von Werkstücken (10; 22; 57; 78), umfassend:
Bereitstellen (30, 31) von Fertigungsdaten für ein Werkstück (10; 22; 57; 78),
Simulieren (32) der Fertigung des Werkstücks (10; 22; 57; 78),
Simulieren (33) von Prüfergebnissen während der Fertigung basierend auf der simulierten Fertigung,
Hinzufügen (34) einer nächsten Gruppe von Schichten zu dem Werkstück (10; 22; 57; 78),
Prüfen (35) der Gruppe von Schichten, um gemessene Prüfergebnisse zu erhalten,
Auswerten (36) des Prüfens basierend auf den simulierten Prüfergebnissen und den entsprechenden
gemessenen Prüfergebnissen,
Wiederholen des Hinzufügens, des Prüfens und des Auswertens, falls das Auswerten eine akzeptable Fertigung anzeigt, und
Ergreifen einer Maßnahme, falls das Auswerten eine inakzeptable Fertigung anzeigt,
wobei das Prüfen (35) ein Durchführen eines Laserultraschallverfahrens umfasst,
und/oder wobei das Prüfen eine Durchführung einer elektronische Laser-Speckle-Interferometrie umfasst und /oder wobei das Prüfen ein Durchführen einer Infrarot-Thermografie umfasst und/oder wobei das Prüfen ein Durchführen einer Röntgenuntersuchung umfasst.

2. Verfahren nach Anspruch 1, wobei das Auswerten ein Auswerten unter Verwendung eines mittels maschinellen Lernens trainierten Systems umfasst.

3. Verfahren nach Anspruch 1 oder 2, wobei das Auswerten ein Vergleichen der simulierten Prüfergebnisse mit den gemessenen Prüfergebnissen umfasst.

4. Verfahren nach einem der Ansprüche 1 bis 3, wobei das Ergreifen einer Maßnahme ein Ändern von Prozessparametern für ein folgendes Hinzufügen einer Gruppe von Schichten umfasst.

5. Verfahren nach einem der Ansprüche 1 bis 4, wobei das Ergreifen einer Maßnahme ein Verwerfen des Werkstücks umfasst.

6. Verfahren nach einem der Ansprüche 1 bis 5, wobei die Gruppe von Schichten eine einzige Schicht, mehrere Schichten oder einen Teil einer Schicht umfasst.

7. Verfahren nach einem der Ansprüche 1 bis 6, wobei das Auswerten eine Verwendung einer vorgegebenen Korrelation von Unterschieden zwischen den gemessenen Prüfergebnissen und den simulierten Prüfergebnissen zu Bauteileigenschaften umfasst.

8. Verfahren nach einem der Ansprüche 1 bis 7, wobei das Hinzufügen in einem Pulverbett erfolgt, wobei beim Laserultraschallverfahren ein Laserstrahl mit einer Pulsfrequenz kleiner als fₘₐₓ = v_{M}/(d_{M} + s_{M}) verwendet wird, wobei v_{M} die Schallgeschwindigkeit im homogenen Pulvermaterial, d_{M} ein mittlerer Partikeldurchmesser des Pulvers des Pulverbettes und s_{M} eine einfache Standardabweichung der Grö-ßenverteilung der Partikel des Pulvers ist.

9. Vorrichtung zur additiven Fertigung von Werkstücken (10; 22; 57; 78), umfassend:
eine Simulationseinrichtung (59; 70) zum Simulieren einer additiven Fertigung eines Werkstücks (10; 22; 57; 78) und zum Simulieren von Prüfergebnissen während der Fertigung,
eine Fertigungseinrichtung (24) zum additiven Fertigen des Werkstücks, und
eine Prüfeinrichtung (50, 53, 55; 71; 79; 710) zum Prüfen des Werkstücks während der additiven Fertigung, um gemessene Prüfergebnisse zu erhalten,
wobei die Prüfeinrichtung eingerichtet ist, das Werkstück jeweils nach dem Hinzufügen einer nächsten Gruppe von Schichten zu prüfen, und die Simulationseinrichtung eingerichtet ist, ein Auswerten auf Basis der simulierten Prüfergebnisse und der gemessenen Prüfergebnisse durchzuführen und zu bewirken, dass eine Maßnahme ergriffen wird, wenn das Auswerten eine inakzeptable Fertigung des Werkstücks anzeigt, und
wobei die Prüfeinrichtung eine Laserultraschallprüfeinrichtung, eine elektronische Laser-Speckle-Interferometrieprüfeinrichtung, eine Infrarot-Thermografieprüfeinrichtung und/oder eine Röntgen-Prüfeinrichtung umfasst.

## Claims

1. Method for additive manufacturing of workpieces (10; 22; 57; 78), comprising:
providing (30, 31) manufacturing data for a workpiece (10; 22; 57; 78),
simulating (32) the manufacturing of the workpiece (10; 22; 57; 78),
simulating (33) test results during the manufacturing on the basis of the simulated manufacturing,
adding (34) a next group of layers to the workpiece (10; 22; 57; 78),
testing (35) the group of layers in order to obtain measured test results,
evaluating (36) the testing on the basis of the simulated test results and the corresponding measured test results,
repeating the adding, the testing and the evaluating if the evaluating indicates acceptable manufacturing, and
implementing a measure if the evaluating indicates unacceptable manufacturing, wherein the testing (35) comprises carrying out a laser ultrasound method,
and/or wherein the testing comprises carrying out electronic laser speckle interferometry, and/or wherein the testing comprises carrying out infrared thermography, and/or wherein the testing comprises carrying out an x-ray examination.

2. Method according to Claim 1, wherein the evaluating comprises evaluating using a system trained by means of machine learning.

3. Method according to Claim 1 or 2, wherein the evaluating comprises comparing the simulated test results with the measured test results.

4. Method according to any of Claims 1 to 3, wherein implementing a measure comprises changing process parameters for subsequently adding a group of layers.

5. Method according to any of Claims 1 to 4, wherein implementing a measure comprises rejecting the workpiece.

6. Method according to any of Claims 1 to 5, wherein the group of layers comprises a single layer, a plurality of layers or a part of a layer.

7. Method according to any of Claims 1 to 6, wherein the evaluating comprises using a predefined correlation of differences between the measured test results and the simulated test results with component properties.

8. Method according to any of Claims 1 to 7, wherein the adding is effected in a powder bed, wherein a laser beam having a pulse frequency of less than fₘₐₓ = v_{M}/(d_{M} + snn) is used in the laser ultrasound method, wherein vnn is the speed of a sound in the homogeneous powder material, d_{M} is a mean particle diameter of the powder of the powder bed and snn is a simple standard deviation of the size distribution of the particles of the powder.

9. Device for additive manufacturing of workpieces (10; 22; 57; 78), comprising:
a simulation unit (59; 70) for simulating additive manufacturing of a workpiece (10; 22; 57; 78) and for simulating test results during the manufacturing,
a manufacturing unit (24) for additive manufacturing of the workpiece, and
a test unit (50, 53, 55; 71; 79; 710) for testing the workpiece during the additive manufacturing in order to obtain measured test results,
wherein the test unit is configured to test the workpiece in each case after a next group of layers has been added, and the simulation unit is configured to carry out evaluating on the basis of the simulated test results and the measured test results and to cause a measure to be implemented if the evaluating indicates unacceptable manufacturing of the workpiece, and
wherein the test unit comprises a laser ultrasound test unit, an electronic laser speckle interferometry test unit, an infrared thermography test unit and/or an x-ray test unit.

## Revendications

1. Procédé de fabrication additive de pièces (10 ; 22 ; 57 ; 78), comprenant :
le fait (30, 31) de fournir des données de fabrication pour une pièce (10 ; 22 ; 57 ; 78),
le fait (32) de simuler la fabrication de la pièce (10 ; 22 ; 57, 78),
le fait (33) de simuler des résultats d'examen pendant la fabrication sur la base de la fabrication simulée,
le fait (34) d'ajouter un groupe suivant de couches à la pièce (10 ; 22 ; 57 ; 78),
le fait (35) d'examiner le groupe de couches pour obtenir des résultats d'examen mesurés,
le fait (36) d'évaluer l'examen sur la base des résultats d'examen simulés et des résultats d'examen mesurés correspondants,
le fait de répéter l'ajout, l'examen et l'évaluation si l'évaluation indique une fabrication acceptable, et
le fait d'entreprendre une action si l'évaluation indique une fabrication inacceptable,
l'examen (35) comprenant la mise en oeuvre d'un procédé à ultrasons laser, et/ou l'examen comprenant la mise en oeuvre d'une interférométrie électronique à balayage laser et/ou l'examen comprenant la mise en oeuvre d'une thermographie infrarouge et/ou l'examen comprenant la mise en oeuvre d'un examen radiographique.

2. Procédé selon la revendication 1, dans lequel l'évaluation comprend une évaluation faite en utilisant un système entraîné par apprentissage automatique.

3. Procédé selon la revendication 1 ou 2, dans lequel l'évaluation comprend une comparaison des résultats d'examen simulés avec les résultats d'examen mesurés.

4. Procédé selon l'une des revendications 1 à 3, dans lequel le fait d'entreprendre une action comprend la modification de paramètres du procédé pour l'ajout ultérieur d'un groupe de couches.

5. Procédé selon l'une des revendications 1 à 4, dans lequel le fait d'entreprendre une action comprend le rejet de la pièce.

6. Procédé selon l'une des revendications 1 à 5, dans lequel le groupe de couches comprend une couche unique, plusieurs couches ou une partie d'une couche.

7. Procédé selon l'une des revendications 1 à 6, dans lequel l'évaluation comprend l'utilisation d'une corrélation prédéterminée des différences entre les résultats d'examen mesurés et les résultats d'examen simulés concernant les propriétés de la pièce.

8. Procédé selon l'une des revendications 1 à 7, dans lequel l'ajout est effectué dans un lit de poudre, le procédé à ultrasons laser utilisant un faisceau laser avec une fréquence d'impulsion inférieure à fₘₐₓ = v_{M}/(d_{M} + s_{M}), v_{M} étant la vitesse du son dans le matériau en poudre homogène, dₘ étant un diamètre moyen de particule de la poudre du lit de poudre et sₘ étant un écart-type simple de la distribution granulométrique des particules de la poudre.

9. Dispositif de fabrication additive de pièces (10 ; 22 ; 57 ; 78), comprenant :
un dispositif de simulation (59 ; 70) pour simuler la fabrication additive d'une pièce (10 ; 22 ; 57 ; 78) et pour simuler les résultats d'examen pendant la fabrication, un dispositif de fabrication (24) pour la fabrication additive de la pièce, et
un dispositif d'examen (50, 53, 55 ; 71, 79 ; 710) pour examiner la pièce pendant la fabrication additive afin d'obtenir des résultats d'examen mesurés,
le moyen d'inspection étant configuré pour vérifier la pièce à chaque fois après avoir ajouté un groupe suivant de couches, et le moyen de simulation étant configuré pour effectuer une évaluation sur la base des résultats d'examen simulés et des résultats d'examen mesurés et pour faire en sorte qu'une action soit entreprise si l'évaluation indique une fabrication inacceptable de la pièce, et
le dispositif d'examen comprenant un dispositif d'examen par ultrasons laser, un dispositif d'examen par interférométrie électronique par balayage laser, un dispositif d'examen par thermographie infrarouge et/ou un dispositif d'examen par rayons X.
